## Europäisches Patentamt

(19) **European Patent Office**

**Office européen des brevets**

(11) Veröffentlichungsnummer: **0 157 145**

**B1**

(12) # EUROPÄISCHE PATENTSCHRIFT

(45) Veröffentlichungstag der Patentschrift:
18.05.88

(51) Int. Cl.⁴: **H 03 H 7/46**

(21) Anmeldenummer: **85101817.6**

(22) Anmeldetag: **20.02.85**

(54) **Antennensteckdose.**

(30) Priorität: **09.03.84 DE 3408658**

(43) Veröffentlichungstag der Anmeldung:
**09.10.85 Patentblatt 85/41**

(45) Bekanntmachung des Hinweises auf die Patenterteilung:
**18.05.88 Patentblatt 88/20**

(84) Benannte Vertragsstaaten:
**AT DE NL**

(56) Entgegenhaltungen:
**DE-A-2 703 258**
**DE-A-3 102 821**
**DE-B-2 151 478**

(73) Patentinhaber: **ROBERT BOSCH GMBH, Postfach 50, D-7000 Stuttgart 1 (DE)**

(72) Erfinder: **Wischmann, Ulrich, Dipl.- Ing., Gravelottestrasse 7, D-1000 Berlin 41 (DE)**

(74) Vertreter: **Schmidt, Hans- Ekhardt, Robert Bosch GmbH Geschäftsbereich Elektronik Patent- und Lizenzabteilung Forckenbeckstrasse 9-13, D-1000 Berlin 33 (DE)**

## Beschreibung

### Stand der Technik

Die Erfindung geht von einer Antennensteckdose nach der im Oberbegriff des Anspruchs 1 angegebenen Gattung aus.

Es sind schon Antennensteckdosen bekannt (Radike, Antennen im Kundendienst, Telekosmos - Verlag, Stuttgart, 1966, Seiten 171 und 172), die als richtungsabhängig übertragendes Schaltelement einen Transformator enthalten, so daß zwischen den Ausgängen zweier im Zuge eines Kabels hintereinanderliegender Antennensteckdosen bzw. zwischen den an die Antennensteckdosen angeschlossenen Empfangsgeräten eine sehr hohe Entkopplung auftritt. Werden an einer Antennensteckdose, die in bekannter Weise einen Ausgang für Rundfunksignale und einen Ausgang für Fernsehsignale aufweist, beide Ausgänge gleichzeitig benutzt - zum Beispiel, wenn mit einem Videorecorder eine Fernsehsendung aufgezeichnet und gleichzeitig eine Hörrundfunksendung abgehört wird -, so kann es zu Störungen kommen. Diese Störungen beruhen auf der verhältnismäßig geringen Entkopplung, die sich durch die in der Antennensteckdose vorhandenen Filter zur Aufteilung der Antennensignalspannung in eine Rundfunksignalspannung und eine Fernsehsignalspannung ergibt. Die Verwendung von Filtern hat auch zur Folge, daß es in den Überlappungsbereichen, zum Beispiel oberhalb des UKW-Bereiches und im unteren Bereich der Sonderkanäle, zu nicht belegbaren Kanälen kommt. Darüber hinaus machen sich in den Randkanälen Dämpfungs- und Gruppenlaufzeitverzerrungen störend bemerkbar.

Aus der DE-A-2 703 258 ist ferner eine Antennensteckdose bekannt, bei der zwei hintereinander geschaltete Richtkoppler vorgesehen sind, von denen jedoch jeder das gesamte verfügbare Frequenzband an jeweils einen Abzweiganschluß auskoppelt. Eine Frequenzbandtrennung ist dabei nicht vorgesehen.

Der vorliegenden Erfindun liegt die Aufgabe zugrunde, eine Antennensteckdose bereitzustellen, zwischen deren Ausgang für die Fernsehsignale und dem Ausgang für die Rundfunksignale eine hohe Entkopplung vorhanden ist und die innerhalb der begrenzten Bandbreite des VHF-Bereiches möglichst alle verfügbaren Kanäle störungsfrei überträgt.

### Vorteile der Erfindung

Die erfindungsgemäße Antennensteckdose mit den kennzeichnenden Merkmalen des Anspruchs 1 hat den Vorteil, daß zwischen dem Anschluß für die Fernsehsignale und dem Anschluß für die Rundfunksignale eine hohe Entkopplung erzielt wird.

Durch die in den Unteransprüchen aufgeführten Merkmale sind vorteilhafte Weiterbildungen und Verbesserungen der im Anspruch 1 angegebenen Antennensteckdose möglich. Besonders vorteilhaft ist eine erfindungsgemäße Antennensteckdose, bei der innerhalb der Antennensteckdose dem Ausgang des einen Auskopplungstransformators ein Filter für die Signale des ersten Frequenzbereiches und dem Ausgang des anderen Auskopplungstransformators ein Filter für die Signale des zweiten Frequenzbereiches zugeordnet ist. Dadurch können überlappende Frequenzbereiche - zum Beispiel Rundfunkbereich: 87,5 ... 125 MHz, Fernsehbereich: 118 ... 450 MHz - realisiert werden. Außerdem werden die nichtgewünschten Frequenzbereiche unterdrückt.

### Zeichnung

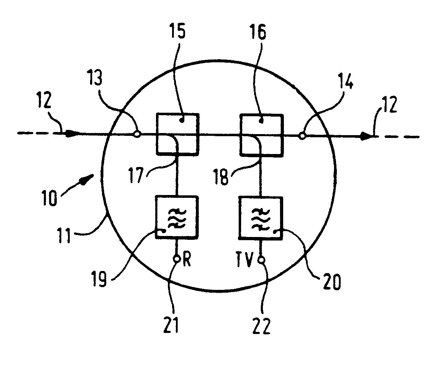

Ein Ausführungsbeispiel der Erfindung ist in der Zeichnung an Hand einer einzigen Figur dargestellt und in der nachfolgenden Beschreibung näher erläutert.

### Bseschreibung der Erfindung

In dem Prinzipschaltbild gemäß der Zeichnung bedeutet 10 eine erfindungsgemäße Antennensteckdose, deren Gehäuse mit 11 bezeichnet ist. Die Antennensteckdose liegt im Zuge eines Kabels 12 und weist einen Eingang 13 sowie einen Ausgang 14 auf. Zwischen dem Eingang und dem Ausgang liegen zwei in Serie geschaltete Auskopplungstransformatoren 15 und 16, deren Abzweige 17 und 18 über je ein Filter 19 und 20 mit einem Rundfunkanschluß 21 bzw. einem Fernsehanschluß 22 verbunden sind.

Die Wirkungsweise der an Hand des Prinzipschaltbildes beschriebenen Antennensteckdose ist folgende. Mit dem Kabel 12, das ist vorzugsweise ein Koaxialkabel in einer Gemeinschaftsantennenanlage, werden Rundfunk- und Fernsehsignale übertragen, die zum Beispiel einen Frequenzbereich von 87,5 MHz bis 450 MHz umfassen. Um die Signale auszukoppeln, werden zwei Auskopplungstransformatoren 15 und 16 verwendet, zwischen deren Abzweigen 17 und 18 eine verhältnismäßig hohe Entkopplung von mindestens 45 dB entsteht. Das Filter 19 ist derart bemessen, daß es nur die Signale des Rundfunkbereichs von zum Beispiel 87,5 MHz bis 125 MHz durchläßt. Diese den UKW-Rundfunkbereich (87,5 ... 108 MHz) und den Satelliten-Rundfunkbereich (111 ... 125 MHz) umfassenden Signale stehen am Rundfunkanschluß 21 zur Verfügung. An den Rundfunkanschluß ist ein Hochfrequenzempfänger angeschlossen, mit dem UKW-Hörrundfunksignale und Satelliten-Rundfunksignale empfangen werden können. Das Filter 20 läßt nur Fernsehsignale mit einer Frequenz zwischen zum Beispiel 118 MHz bis 450 MHz durch, das heißt im wesentlichen Frequenzen des VHF-Bereiches. In diesem Fall überlappen sich Rundfunk- und Fernsehbereich, ohne daß es dadurch zu störenden Beeinflussungen zwischen den an den Ausgängen 21 und 22 angeschlossenen Empfangsgeräten kommen kann. Die auszukoppelnden Signale können gegebenenfalls auch einem einzigen Frequenzbereich, zum Beispiel dem Fernsehbereich, angehören, so daß an den Ausgängen 21 und 22 der Antennensteckdose 10 zwei verschiedene Fernsehsignale zur Verfügung stehen.

## Patentansprüche

1. Antennensteckdose, die im Zuge eines Kabelnetzes einer Verteilanlage liegt und die Mittel zum Auskoppeln von Signalen eines ersten Frequenzbereiches und Signalen eines zweiten Frequenzbereiches enthält, dadurch gekennzeichnet, daß die Antennensteckdose (10) zwei in Serie geschaltete Auskopplungstransformatoren (15, 16) enthält und daß am Ausgang des einen Auskopplungstransformators nur die Signale des ersten Frequenzbereiches und am Ausgang des anderen Auskopplungstransformators nur die Signale des zweiten Frequenzbereiches abnehmbar sind.

2. Antennensteckdose nach Anspruch 1, dadurch gekennzeichnet, daß innerhalb der Antennensteckdose (10) dem Ausgang (17) des einen Auskopplungstransformators (15) ein erstes Filter (19) für die Signale des ersten Frequenzbereiches und dem Ausgang (18) des anderen Auskopplungstransformators (16) ein zweites Filter (20) für die Signale des zweiten Frequenzbereiches zugeordnet ist.

## Claims

1. An antenna plug socket which is located in the course of a cable network of a distribution system and which includes means for the decoupling of signals of a first frequency range and signals of a second frequency range, characterised in that the antenna plug socket (10) includes two series-connected decoupling transformers (15, 16), and that only the signals of the first frequency range can be taken from the output of one of the decoupling transformers, and only the signals of the second frequency range can be taken from the output of the other decoupling transformer.

2. An antenna plug socket as claimed in claim 1, characterised in that within the antenna plug socket (10) a first filter (19) for the signals of the first frequency range is associated with the output (17) of one decoupling transformer (15), and a second filter (20) for the signals of the second frequency range is associated with the output (18) of the other decoupling transformer (16).

## Revendications

1. Boîtier de prise d'antenne branché sur un réseau câblé d'une installation de distribution et qui comporte des moyens de découplage des signaux d'une première plage de fréquence et des signaux d'une seconde plage de fréquence, caractérisé en ce que le boîtier de prise d'antenne (10) comporte deux transformateurs de découplage (15, 16) branchés en série et en ce qu'à la sortie de l'un des transformateurs de découplage n'apparaissent que les signaux de la première plage de fréquence et à la sortie de l'autre transformateur de découplage n'apparaissent que les signaux de la seconde plage de fréquence.

2. Boîtier de prise d'antenne selon la revendication 1, caractérisé en ce qu'à l'intérieur du boîtier (10), un premier filtre (19) pour les signaux de la première plage de fréquence est associé à la sortie (17) de l'un des transformateurs de découplage (15) et un second filtre (20) pour les signaux de la seconde plage de fréquence est associé à la sortie (18) de l'autre transformateur de découplage.